(19) **Europäisches Patentamt / European Patent Office / Office européen des brevets**

(11) **EP 1 523 771 B1**

(12) **FASCICULE DE BREVET EUROPEEN**

(45) Date de publication et mention
de la délivrance du brevet:
**10.03.2010 Bulletin 2010/10**

(21) Numéro de dépôt: **03750808.2**

(22) Date de dépôt: **15.07.2003**

(51) Int Cl.:
***H01L 21/762*** (2006.01)

(86) Numéro de dépôt international:
**PCT/FR2003/002225**

(87) Numéro de publication internationale:
**WO 2004/010494 (29.01.2004 Gazette 2004/05)**

(54) **PROCEDE DE TRANSFERT D'UNE COUCHE MINCE ELECTRIQUEMENT ACTIVE.**

VERFAHREN ZUR ÜBERTRAGUNG EINER DÜNNEN, ELEKTRISCH AKTIVEN SCHICHT

METHOD FOR TRANSFERRING AN ELECTRICALLY ACTIVE THIN LAYER

(84) Etats contractants désignés:
**AT BE BG CH CY CZ DE DK EE ES FI FR GB GR HU IE IT LI LU MC NL PT RO SE SI SK TR**

(30) Priorité: **18.07.2002 FR 0209118**

(43) Date de publication de la demande:
**20.04.2005 Bulletin 2005/16**

(73) Titulaires:
• **S.O.I. Tec Silicon on Insulator Technologies S.A.**
**38190 Bernin (FR)**
• **Soitec**
**Bernin,**
**38926 Crolles Cedex (FR)**

(72) Inventeurs:
• **DI CIOCCIO, Léa**
**F-38330 SAINT ISMIER (FR)**
• **LETERTRE, Fabrice**
**F-38000 GRENOBLE (FR)**
• **HUGONNARD-BRUYERE, Elsa**
**F-13710 FUVEAU (FR)**

(74) Mandataire: **Poulin, Gérard et al**
**Brevalex**
**3, rue du Docteur Lancereaux**
**75008 Paris (FR)**

(56) Documents cités:
**WO-A-02/37556      US-A- 6 150 239**

• **HUGONNARD-BRUYERE E ET AL: "Electrical and physical behavior of SiC layers on insulator (SiCOI)" INTERNATIONAL CONFERENCE ON SILICON CARBIDE AND RELATED MATERIALS, ICSRM'99, RESEARCH TRIANGLE PARK, NC, USA, 10-15 OCT. 1999, vol. 338-342, pt.1, pages 715-718, XP008017315 Materials Science Forum, 2000, Trans Tech Publications, Switzerland ISSN: 0255-5476**
• **HUGONNARD-BRUYERE E ET AL: "Defect Studies in Epitaxial SiC-6H Layers on Insulator (SiCOI)" MICROELECTRONIC ENGINEERING, ELSEVIER PUBLISHERS BV., AMSTERDAM, NL, vol. 48, no. 1-4, septembre 1999 (1999-09), pages 277-280, XP004193305 ISSN: 0167-9317**
• **HUGONNARD-BRUYERE E ET AL: "Deep level defects in Himplanted 6H-SiC epilayers and in silicon carbide on insulator structures" MATERIALS SCIENCE AND ENGINEERING B, ELSEVIER SEQUOIA, LAUSANNE, CH, vol. 61-62, 30 juillet 1999 (1999-07-30), pages 382-388, XP004363371 ISSN: 0921-5107**
• **GREGORY R B ET AL: "The effects of damage on hydrogen-implant-induced thin-film separation from bulk silicon carbide" WIDE-BANDGAP SEMICONDUCTORS FOR HIGH-POWER, HIGH-FREQUENCY AND HIGH-TEMPERATURE APPLICATIONS - 1999. SYMPOSIUM, WIDE-BANDGAP SEMICONDUCTORS FOR HIGH-POWER, HIGH-FREQUENCY AND HIGH-TEMPERATURE APPLICATIONS - 1999. SYMPOSIUM, SAN FRANCISCO, CA, USA, 5-, pages 33-38, XP001040858 1999, Warrendale, PA, USA, Mater. Res. Soc, USA**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

- **BINARI S C ET AL: "H, He, and N implant isolation of n-type GaN" JOURNAL OF APPLIED PHYSICS, AMERICAN INSTITUTE OF PHYSICS. NEW YORK, US, vol. 78, no. 5, 1 septembre 1995 (1995-09-01), pages 3008-3011, XP002185242 ISSN: 0021-8979**

**Description**

**DOMAINE TECHNIQUE**

L'invention concerne un procédé de transfert d'une couche mince électriquement active depuis un substrat initial vers un substrat cible.

Elle s'applique, en particulier, au transfert d'une couche mince de matériau semi-conducteur et notamment au transfert d'une couche mince de carbure de silicium.

**ETAT DE LA TECHNIQUE ANTERIEURE**

Le document FR-A-2 681 472 (correspondant au brevet américain n°5 374 564) divulgue un procédé de fabrication de films minces de matériau semi-conducteur. Le film mince est d'abord délimité dans un substrat initial par implantation ionique. Une face du substrat est bombardée par des ions (généralement des ions hydrogène) selon une dose et une énergie déterminées pour créer une couche enterrée fragilisée à une profondeur, par rapport à la face bombardée, voisine de la profondeur moyenne de pénétration des ions dans le substrat. La face bombardée du substrat est ensuite solidarisée avec une face d'un substrat de réception ou raidisseur. Un recuit permet alors d'obtenir une séparation du film mince d'avec le reste du substrat initial. On obtient alors un film mince adhérant au raidisseur. Cette technique est maintenant bien connue et bien maîtrisée. Elle permet l'obtention de substrats SOI de qualité électronique.

Ce procédé a été appliqué après plusieurs adaptations au semi-conducteur carbure de silicium pour obtenir un empilement de couchés appelé SiCOI et constitué d'un substrat de silicium recouvert successivement d'une couche d'oxyde de silicium et d'une couche de carbure de silicium. On peut se reporter à ce sujet à l'article "Silicon carbide on insulator formation by the Smart-Cut® process" de L. Di Cioccio et al., Materials Science and Engineering B46 (1997), pages 349 à 356.

Dans le cadre de ces développements réalisés sur le substrat SiCOI, le problème de la résistivité électrique de la couche mince de SiC transférée a été étudié.

Les premières couches de SiC transférées sur du silicium oxydé avaient complètement perdu leur caractère conducteur électrique, induit initialement par un dopage approprié, et étaient devenues complètement isolantes. Il a été mis en évidence que la compensation électrique introduite dans les films transférés et responsable de ce caractère isolant acquis, est liée aux défauts d'implantation créés dans le matériau par le passage des protons utilisés pour réaliser l'implantation. On peut se reporter à ce sujet aux articles suivants :

- "Defect Studies in Epitaxial SiC-6H Layers on Insulator (SiCOI)" de E. Hugonnard-Bruyère et al., Microelectronic Engineering 48 (1999), pages 277 à 280 ;
- "High-resistance layers in n-type 4H-silicon carbide by hydrogen ion implantation" de R.K. Nadella et al., Appl. Phys. Lett. 70(7), 17 février 1997, pages 886 à 888 ;
- "Electrical isolation of GaN by ion implantation damage : Experiment and model" de C. Uzan-Saguy et al., Applied Physics Letters, Vol. 74, N°17, 26 avril 1999, pages 2441 à 2443.

La forte dose de protons nécessaires pour obtenir le transfert d'une couche mince de SiC crée, sur tout le parcours de ces ions entre la surface d'implantation et la profondeur moyenne d'implantation des ions, une concentration de défauts d'implantation qui se comportent d'un point de vue électrique comme des centres accepteurs.

Le dopage initial, de type n obtenu, par exemple, par le dopant azote ou de type p obtenu, par exemple, par le dopant aluminium, des couches minces de SiC étudiées varie entre $10^{19}$ atomes/cm$^3$ et $10^{15}$ atomes/cm$^3$. Les couches minces dopées provenaient soit d'une épitaxie, soit du substrat massif lui-même. Un raisonnement simple montre que si la concentration de centres compensateurs résiduels dans la couche mince transférée, introduite par le procédé mis en oeuvre, est supérieure au dopage initial (concentration de centres donneurs), la couche mince transférée présente un comportement fortement résistif (voir l'article de E. Hugonnard-Bruyère cité ci-dessus).

Cette concentration de défauts accepteurs dépend d'une part, de la concentration de défauts d'implantation créée par l'implantation de protons et d'autre part de la capacité des étapes technologiques appliquées à la couche mince transférée à s'affranchir de ces défauts et diminuer ainsi le plus possible leur concentration.

D'un point de vue électronique, une couche mince semi-conductrice comportant des 'défauts compensateurs ne va pas avoir des propriétés de transport (concentration de porteurs) compatibles avec la fabrication d'un dispositif électronique. Aussi, il est impératif qu'après la réalisation d'une structure SiCOI par le procédé divulgué par le document FR-A-2 681 472, la couche transférée puisse être utilisée pour fabriquer un dispositif électronique.

De nombreuses équipes ont étudié la génération de défauts d'implantation ainsi que les conditions de leur annihilation. Il ressort de ces études que pour le SiC certains défauts d'implantation créés par des ions légers comme l'hydrogène peuvent être stables pour des températures de recuit allant jusqu'à 1500°C même si, pour des dopages

supérieurs à $2.10^{18}$ atomes/cm$^3$, des recuits de l'ordre de 1300°C suffisent pour récupérer la résistivité initiale (voir l'article de E. Hugonnard-Bruyère cité plus haut). Néanmoins, dans ces conditions de fabrication, la compensation électrique résiduelle reste importante. L'article "The effects of damage on hydrogen-implant-induced thin-film separation from bulk silicon carbide" de R.B. Gregory et al., Mat. Res. Soc. Symp. Proc. Vol. 572, 1999, Materials Research Society, pages 33 à 38, divulgue qu'une implantation à haute température permet de guérir une partie des défauts sans pour autant s'en affranchir complètement.

Il est bien évident que le fait de transférer par cette technique une couche mince de SiC sur un substrat en silicium ne permet pas d'appliquer des traitements thermiques aussi poussés puisque le silicium fond à 1413°C.

Enfin, de façon générale, même si la couche de collage (voire l'absence de couche de collage) et l'utilisation d'un support autre que le silicium (du SiC polycristallin par exemple) permettaient un tel apport thermique, cela ne suffirait pas à récupérer une résistivité correcte, compte tenu de la forte concentration de défauts introduits et de leur stabilité thermique, et ne serait pas souhaitable puisque de telles températures sont peu courantes dans l'industrie microélectronique.

Enfin, l'implantation à haute température est difficile à mettre en oeuvre de façon industrielle et ne permet pas de récupérer entièrement la conduction électrique correspondant au dopage initial.

Le document « Deep level defects in H+ implanted 6H-SiC epilayers and in silicon carbide on insulator structures" de E. Hugonnard-Bruyère et al., Materials Science and Engineering, B 61-62, 1999, pages 382 à 388, divulgue le transfert d'une couche de SiC depuis un substrat initial jusqu'à un substrat final par un procédé comprenant une étape d'implantation ionique au travers d'une face du substrat initial, une étape de solidarisation de la face implantée du substrat initial sur une face du substrat cible, une étape de séparation de la couche de SiC du reste du substrat initial et une étape d'amincissement de la couche de SiC transférée. L'étape d'amincissement est effectuée pour analyser la couche de SiC dans son épaisseur.

US 6 150 239 divulgue un procédé de transfert d'une couche mince, par exemple en SiC, mettant en oeuvre les étapes d'implantation ionique, de solidarisation et de séparation décrites dans le document précédent.

## EXPOSÉ DE L'INVENTION

Pour remédier aux inconvénients de l'art antérieur, il est ici proposé un procédé de fabrication permettant d'obtenir une couche de matériau semi-conducteur sur un support avec une compensation électrique résiduelle, due à l'implantation ionique, négligeable.

L'invention a donc pour objet un procédé de transfert d'une couche mince électriquement active depuis Un substrat initial vers un substrat cible, comprenant les étapes suivantes :

- implantation ionique au travers d'une face du substrat initial pour créer une couche enterrée fragilisée à une profondeur déterminée par rapport à la face implantée du substrat initial, une couche mince étant ainsi délimitée entre la face implantée et la couche enterrée,
- solidarisation de la face implantée du substrat initial -sur une face du substrat cible,
- séparation de la couche mince d'avec le reste du substrat initial au niveau de la couche enterrée,
- amincissement de la couche mince transférée sur le substrat cible,

**caractérisé en ce que,** le substrat initial étant en SiC, la dose, l'énergie et le courant d'implantation sont choisis, lors de l'étape d'implantation ionique, pour que la concentration en défauts d'implantation dans les premiers 500 nm implantés de SiC soit inférieure à $9.10^{20}$ atomes/cm$^3$; conduisant à obtenir dans la couche mince de SiC amincie à une épaisseur inférieure à 500 nm un nombre de défauts accepteurs compatible avec les propriétés électriques désirées pour la couche mince.

L'étape d'implantation ionique peut consister à implanter des ions choisis parmi l'hydrogène et les gaz rares.

L'étape de solidarisation peut mettre en oeuvre un collage choisi parmi le collage par adhésion moléculaire via des couches intermédiaires ou sans couches intermédiaires, le collage par rédaction, le collage métallique, la brasure et le collage par diffusion, d'espaces.

Avantageusement, un recuit de guérison des défauts d'implantation est réalisé sur la couche mince. Ce recuit de guérison peut être réalisé avant ou après d'amincissement de la couche mince.

## BRÈVE DESCRIPTION DES DESSINAS

L'invention sera mieux comprise et d'autres avantages et particularités apparaîtront à la lecture de la description qui va suivre, donnée à titre d'exemple non limitatif, accompagnée des dessins annexés parmi lesquels :

- la figure 1 est un diagramme représentant le profil de défauts accepteurs dans un substrat initial implanté,

- la figure 2 est un diagramme représentant la concentration de lacunes créées en fonction de la profondeur du substrat initial implantés.

## EXPOSÉ DÉTAILLÉ DE MODES DE RÉALISATION PARTICULIERS

Le nombre de défauts accepteurs dans la couche mince transférée et amincie selon la présente invention dépend du profil de défauts qui est créé dans le couche mince transférée (distribution des défauts selon l'épaisseur de la couche mince). Ce profil de défauts dépend de l'énergie d'implantation. Le choix des conditions d'implantation (énergie d'implantation, épaisseur du masque d'implantation) est crucial et permet de définir l'épaisseur de la future couche active.

Les inventeurs sont arrivés à la conclusion que le profil des défauts électriques compensateurs est proportionnel au profil des défauts d'implantation. Il est donc nécessaire de générer, par le choix des conditions d'implantation, une couche mince qui contient, après implantation, au moins une zone avec un profil de défauts suffisamment plat pour que la concentration finale résiduelle de défauts soit répartie de manière homogène dans la couche devant subsister. Le reste de la couche transférée, dont le profil de défauts n'est plus plat, est éliminé par amincissement.

Le nombre de défauts accepteurs dans la couche mince transférée et amincie selon la présente invention dépend aussi de la concentration de défauts d'implantation créée par l'irradiation de protons. Le paramètre jouant sur la concentration de défauts est la dose d'implantation et le courant d'implantation. Les inventeurs de la présente invention ont constaté que le courant d'implantation permet de jouer sur l'efficacité de création de défauts. Ainsi, implanter à faible densité de courant permet de diminuer la concentration de défauts. L'autre paramètre est la dose d'ions implantés. Il est possible de diminuer de manière significative la dose d'ions implantés dans le substrat initial en réalisant l'implantation à haute température ou en jouant sur l'effet canalisation.

Le nombre de défauts accepteurs dans la couche mince transférée et amincie selon la présente invention dépend enfin de traitements postérieurs (ou de guérison) du type recuits. Pour le carbure de silicium notamment, certains défauts d'implantation créés par des ions légers comme l'hydrogène peuvent être stables pour des températures de recuit allant jusqu'à 1500°C.

Suivant cette approche, le point critique qui apparaît est la définition de la future couche active (c'est-à-dire la couche obtenue après amincissement). Cette couche est entièrement définie par le profil des défauts créés par le passage des ions implantés ainsi que par la capacité guérissante des étapes technologiques postérieures à la fracture du substrat initial.

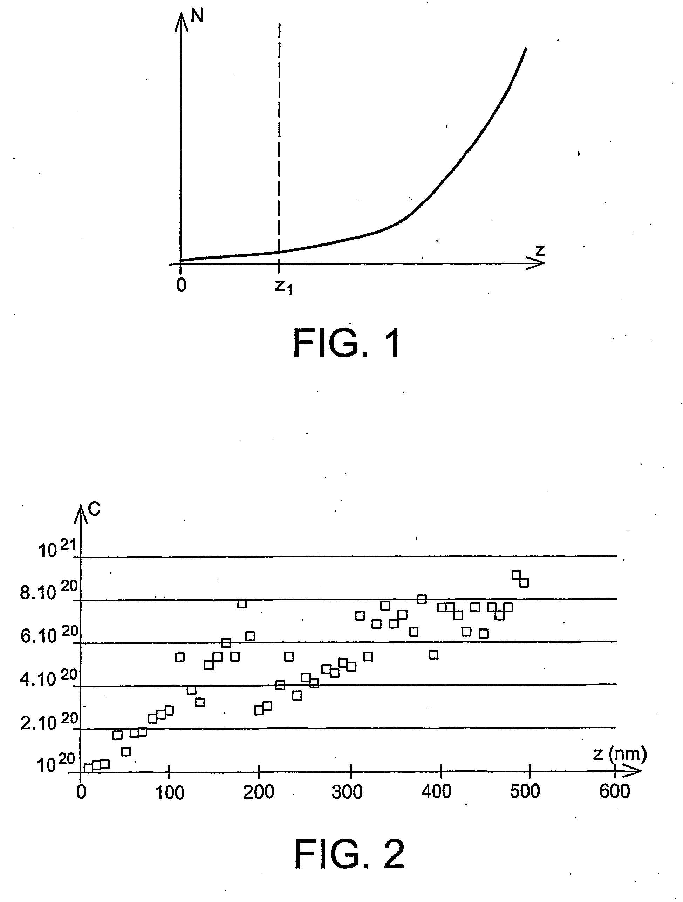

La figure 1 est un diagramme représentant le profil de défauts accepteurs dans un substrat initial implanté. L'axe des ordonnées représente le nombre N de défauts accepteurs. L'axe des abscisses représente la profondeur z du substrat à partir de la face implantée (abscisse 0). L'abscisse $z_1$ donne l'épaisseur de la couche mince après amincissement permettant l'obtention d'une couche mince possédant les propriétés électriques désirées.

Une loi empirique liant le profil de défauts électriques persistant dans la couche mince avec le profil de défauts créés lors de l'implantation a pu être établie. Ce profil post-implantation peut être donné, avec une bonne précision, par le logiciel TRIM permettant de simuler la création de défauts cristallins élémentaires (lacunes de C et de Si dans le cas du carbure de silicium) lors d'une étape d'implantation ionique.

La figure 2 est un diagramme représentant la concentration C de lacunes créées (en atomes/cm$^3$) en fonction de la profondeur z du substrat à partir de la face implantée (abscisse 0). Ce diagramme a été obtenu par simulation à partir du logiciel TRIM pour du carbure de silicium implanté par des ions H$^+$ (énergie d'implantation 180 keV, dose d'implantation $6,5.10^{16}$ ions/cm$^2$). Pour une énergie d'implantation de 180 keV, la profondeur moyenne d'implantation $R_p$ est supérieure à 1100 nm.

Des mesures par effet Hall ont été effectuées pour un substrat initial en SiC et pour ces conditions d'implantation. Elles donnent une concentration résiduelle moyenne de défauts accepteurs de $4.10^{16}$ atomes/cm$^3$ pour un film de SiC de 0,5 μm d'épaisseur. La simulation TRIM indique que la concentration de défauts présents dans les 0,5 premiers μm du film implanté est toujours inférieure à $9.10^{20}$ atomes/cm$^3$. La concentration de défauts dans cette couche est inférieure, en tout point, à la concentration maximale de $9.10^{20}$ atomes/cm$^3$. Cela signifie qu'à l'issue du procédé selon l'invention la concentration finale de défauts résiduels sera toujours inférieure à $9.10^{20}$ K. Grâce à la mesure électrique donnant une concentration moyenne dans tout le film, on peut estimer le coefficient K liant les défauts physiques créés et les défauts électriques résiduels:

$$K = 4.10^{16}/9.10^{20} = 4,5.10^{-5}$$

avec la relation $C_f = K.C_i$

Ci est la concentration moyenne de défauts primaires d'implantation et dépend de la façon dont est réalisée l'implantation dans le matériau (c'est-à-dire son profil d'implantation). $C_f$ est la concentration moyenne de défauts finaux électriques dans la couche mince après transfert et recuit. K est un coefficient de proportionnalité lié aux étapes de recuit (guérison des défauts).

Pour une implantation d'hydrogène réalisée sans chauffage intentionnel dans du SiC à travers une couche de SiO$_2$ inférieure à 50 nm, pour une énergie de 180 keV, une dose de 6,5.10$^{16}$ atomes/cm$^2$ et un budget thermique maximal à la couche mince transférée de 1350°C pendant 48 heures, le coefficient K est égal à environ 4,5.10$^{-5}$. Ceci signifie que le procédé mis en oeuvre permet de diminuer d'un facteur 2,25.10$^4$ la concentration de défauts créés.

On va maintenant détailler un exemple de mise en oeuvre du procédé selon l'invention et permettant d'obtenir une couche mince de SiC transférée d'épaisseur finale inférieure ou égale à 0,5 $\mu$m.

Une surface plane d'un substrat initial de SiC monocristallin est polie mécaniquement et mécano-chimiquement. On fait croître par épitaxie une couche mince de SiC au dopage désiré (par exemple 10$^{17}$ atomes d'impuretés/cm$^3$) sur la face polie du substrat. Cette étape n'est nécessaire que si l'on souhaite transférer une couche mince avec un dopage inférieur au dopage résiduel d'un substrat ou possédant une meilleure qualité cristalline. La couche épitaxiée peut recevoir un polissage mécanique ou mécanochimique pour obtenir une surface permettant l'adhésion moléculaire. On procède ensuite à une oxydation thermique pour obtenir une couche d'oxyde de 50 nm d'épaisseur. Une variante consiste à déposer un oxyde sur une épaisseur ne dépassant par 50 nm.

La face oxydée du substrat initial est soumise à une implantation d'hydrogène pour une énergie de 180 keV et une dose de 6,5.10$^{16}$ atomes/cm$^2$ afin de créer une couche fragilisée délimitant la couche mince à transférer. Il est possible de diminuer de manière significative cette dose limite en implantant l'hydrogène à haute température. Par exemple, à une température d'implantation de l'ordre de 650°C, la dose critique passe de 6,5.10$^{16}$ à environ 4,5.10$^{16}$ atomes/cm$^2$. Cette implantation est réalisée afin de générer sur les 500 premiers nm de la couche de SiC une concentration de défauts simulée inférieure à 9.10$^{20}$ atomes/cm$^3$.

La surface de l'oxyde implanté est nettoyée, de même que la surface de l'oxyde présent sur le substrat cible. Ces surfaces sont alors activées spécifiquement, par exemple par polissage mécanochimique. Les surfaces ainsi traitées sont alors collées par adhésion moléculaire.

On réalise ensuite le transfert de la couche mince délimitée en provoquant une fracture au sein du substrat initial, au niveau de la zone fragilisée. La fracture peut être obtenue par un traitement thermique adapté.

La couche mince transférée sur le substrat cible est recuite à très haute température (1350°C). Un recuit oxydant permet de consommer par oxydation, de manière contrôlée, la couche mince de SiC, d'éxodiffuser l'hydrogène présent dans la couche mince et de guérir les défauts d'implantation. La durée du recuit est prévue pour guérir les défauts d'implantation. Elle peut être de 48 heures.

On procède ensuite à la désoxydation de la couche mince de SiC.

La couche mince est alors amincie par gravure ionique ou par oxydation thermique pour ajuster la couche mince à l'épaisseur voulue (inférieure à 0,5 $\mu$m). Cette étape peut être réalisée avant l'étape de recuit à très haute température.

Le procédé selon l'invention peut s'appliquer à tout matériau que l'on veut transférer par le procédé Smart-Cut® mais dont la résistivité électrique par la suite pose problème (SiC, GaAs, InP, GaN, diamant par exemple).

D'autres collages que l'adhésion moléculaire via des couches intermédiaires d'oxyde peuvent être utilisés : adhésion moléculaire sans couches intermédiaires, collage par réaction, collage métallique, brasure, collage par diffusion d'espèces. L'implantation ionique peut être réalisée avec d'autres espèces ioniques que l'hydrogène, par exemple l'hélium.

## Revendications

1. Procédé de transfert d'une couche mince électriquement active depuis un substrat initial vers un substrat cible, comprenant les étapes suivantes :

    - implantation ionique au travers d'une face du substrat initial pour créer une couche enterrée fragilisée à une profondeur déterminée par rapport à la face implantée du substrat initial, une couche mince étant ainsi délimitée entre la face implantée et la couche enterrée,
    - solidarisation de la face implantée du substrat initial sur une face du substrat cible,
    - séparation de la couche mince d'avec le reste du substrat initial au niveau de la couche enterrée,
    - amincissement de la couche mince transférée sur le substrat cible,

    **caractérisé en ce que,** le substrat initial étant en SiC, la dose, l'énergie et le courant d'implantation sont choisis, lors de l'étape d'implantation ionique, pour que la concentration en défauts d'implantation dans les premiers 500 nm implantés de SiC soit inférieure à 9.10$^{20}$ atomes/cm$^3$, conduisant à obtenir dans la couche mince de SiC amincie à une épaisseur inférieure à 500 nm un nombre de défauts accepteurs compatible avec les propriétés électriques désirées pour la couche mince.

2. Procédé selon la revendication 1, **caractérisé en ce que** l'étape d'implantation ionique consiste à implanter des ions choisis parmi les espèces suivantes : hydrogène et gaz rares.

3. Procédé selon la revendication 1, **caractérisé en ce que** l'étape de solidarisation met en oeuvre un collage choisi parmi le collage par adhésion moléculaire via des couches intermédiaires ou sans couches intermédiaires, le collage par réaction, le collage métallique, la brasure et le collage par diffusion d'espèces.

4. Procédé selon la revendication 1, **caractérisé en ce qu'**un recuit de guérison des défauts d'implantation est réalisé sur la couche mince.

5. Procédé selon la revendication 4, **caractérisé en ce que** le recuit de guérison est réalisé avant l'étape d'amincissement de la couche mince.

6. Procédé selon la revendication 4, **caractérisé en ce que** le recuit de guérison est réalisé après l'étape d'amincissement de la couche mince.


**Claims**

1. Method for transferring an electrically active thin film from an initial substrate to a target substrate, comprising the following steps:

   - ion implantation through one face of said initial substrate in order to create a buried, embrittled film at a determined depth in relation to the implanted face of the initial substrate, a thin film thus being delimited between the implanted face and the buried face,
   - fastening the implanted face of the initial substrate with a face of the target substrate,
   - separating the thin film from the remainder of the initial substrate at the level of the buried film,
   - thinning down the thin film transferred on the target substrate,

   **characterised in that,** the initial substrate being in SiC, the implantation dosage, energy and current are chosen, during the ion implantation step, so that the concentration of implantation defects in the first implanted 500 nm of SiC is less than $9.10^{20}$ atoms/cm$^3$, resulting in, within the SiC thin film thinned to a thickness less than 500 nm, a number of acceptor defects that is compatible with the desired electrical properties of the thin film.

2. Method according to claim 1, **characterised in that** the ion implantation step consists in implanting ions chosen from among the following species: hydrogen and rare gases.

3. Method according to claim 1, **characterised in that** the step of fastening involves a bonding chosen from bonding by molecular adhesion via intermediate films or without intermediate films, bonding by reaction, metallic bonding, brazing or bonding by species diffusion.

4. Method according to claim 1, **characterised in that** a healing annealing of the implantation defects is carried out on the thin film.

5. Method according to claim 4, **characterised in that** the healing annealing is carried out before the step of thinning down the thin film.

6. Method according to claim 4, **characterised in that** the healing annealing is carried out after the step of thinning down the thin film.


**Patentansprüche**

1. Transferverfahren einer elektrisch aktiven Dünnschicht von einem ursprünglichen Substrat zu einem Zielsubstrat, das die folgenden Schritte aufweist:

- Ionenimplantation durch eine Seite des ursprünglichen Substrats, um eine fragilisierte überdeckte Schicht mit einer bestimmten Tiefe im Vergleich zu der implantierten Seite des ursprünglichen Substrats zu schaffen, wobei daher eine Dünnschicht zwischen der implantierten Seite und der überdecken Seite abgegrenzt wird,
- Haftverbinden der implantierten Seite des ursprünglichen Substrats auf einer Seite des Zielsubstrats,
- Trennen der Dünnschicht von dem Rest des ursprünglichen Substrats auf dem Niveau der überdecken Schicht,
- Verdünnen der auf das Zielsubstrat transferierten Dünnschicht,

**dadurch gekennzeichnet, dass**, weil das ursprüngliche Substrat aus SiC ist, die Dosis, die Energie und der Implantation beim Schrift der Ionenimplantation ausgewählt werden, so dass die Konzentration an Implantationsmängeln in den ersten 500 nm implantiertem SiC kleiner ist als $9.10^{20}$ Atome/cm$^3$, was dazu führt, in der auf 500 nm verdünnten SiC-Dünnschicht eine Anzahl Akzeptormängel zu erzielen, die mit den für die Dünnschicht erwünschten elektrischen Eigenschaften kompatibel ist.

2. Verfahren nach Anspruch 1, **dadurch gekennzeichnet, dass** der Ionenimplantationsschritt darin besteht, ausgewählte Ionen der folgenden Arten zu implantieren: Wasserstoff und Edelgase.

3. Verfahren nach Anspruch 1, **dadurch gekennzeichnet, dass** der Haftschritt ein Klebern umsetzt, das aus dem Kleben durch Molekularadhäsion über Zwischenschichten oder ohne Zwischenschichten, dem Kleben durch Reaktion, dem metallischen Klebern, dem Löten und dem Kleben durch Artendiffusion ausgewählt ist.

4. Verfahren nach Anspruch 1, **dadurch gekennzeichnet, dass** ein Sanierungsglühen der Implantationsmängel auf der Dünnschicht ausgeführt wird.

5. Verfahren nach Anspruch 4, **dadurch gekennzeichnet, dass** das Sanierungsglühen vor dem Verdünnungsschritt der Dünnschicht ausgeführt wird.

6. Verfahren nach Anspruch 4, **dadurch gekennzeichnet, dass** das Sanierungsglühen nach dem Verdünnungsschritt der Dünnschicht ausgeführt wird.

FIG. 1

FIG. 2

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2681472 A
- US 5374564 A
- US 6150239 A

**Littérature non-brevet citée dans la description**

- **L. Di Cioccio et al.** Silicon carbide on insulator formation by the Smart-Cut® process. *Materials Science and Engineering,* 1997, vol. B46, 349-356
- **E. Hugonnard-Bruyère et al.** Defect Studies in Epitaxial SiC-6H Layers on Insulator (SiCOI). *Microelectronic Engineering,* 1999, vol. 48, 277-280
- **R.K. Nadella et al.** High-resistance layers in n-type 4H-silicon carbide by hydrogen ion implantation. *Appl. Phys. Lett.,* 17 Février 1997, vol. 70 (7), 886-888
- **C. Uzan-Saguy et al.** Electrical isolation of GaN by ion implantation damage : Experiment and model. *Applied Physics Letters,* 26 Avril 1999, vol. 74 (17), 2441-2443
- **R.B. Gregory et al.** The effects of damage on hydrogen-implant-induced thin-film separation from bulk silicon carbide. *Mat. Res. Soc. Symp. Proc.,* 1999, vol. 572, 33-38
- **E. Hugonnard-Bruyère et al.** Deep level defects in H+ implanted 6H-SiC epilayers and in silicon carbide on insulator structures. *Materials Science and Engineering,* 1999, vol. B 61-62, 382-388